# EUROPÄISCHE PATENTSCHRIFT

(11) **EP 3 320 373 B1**
(45) Veröffentlichungstag und Bekanntmachung des Hinweises auf die Patenterteilung: **17.08.2022**
(21) Anmeldenummer: 16744313.4
(22) Anmeldetag: 05.07.2016
(51) Int. Cl.: G01T 1/208, H01J 43/02, H03H 7/46

(54) **FILTERSCHALTUNG ZUR UNTERDRÜCKUNG EINER SIGNALVERZERRUNG**
FILTER CIRCUIT FOR SUPPRESSING SIGNAL DISTORTION
CIRCUIT DE FILTRAGE POUR RÉDUIRE UNE DISTORSION DE SIGNAL

(30) Priorität: 09.07.2015 DE 102015212845
(43) Veröffentlichungstag der Anmeldung: 16.05.2018
(73) Patentinhaber: Forschungszentrum Jülich GmbH, 52425 Jülich (DE)
(72) Erfinder: GREWING, Christian, 52428 Jülich (DE); ROBENS, Markus, 52074 Aachen (DE)
(74) Vertreter: dompatent von Kreisler Selting Werner - Partnerschaft von Patent- und Rechtsanwälten mbB
(86) Internationale Anmeldenummer: PCT/EP2016/065850
(87) Internationale Veröffentlichungsnummer: WO 2017/005744

(56) Entgegenhaltungen:
- WO-A1-93/10553
- US-A- 4 918 314
- US-A1- 2007 063 771
- US-A1- 2011 098 980
- "Chapter 5. How to use Photomultiplier Tubes and Peripheral Circuits", INTERNET CITATION, 1. Januar 2006 (2006-01-01), Seiten 83-112, XP007908696, Gefunden im Internet: URL:http://sales.hamamatsu.com/assets/appl ications/ETD/pmt_handbook_complete.pdf [gefunden am 2007-03-07]

## Beschreibung

### Gebiet der Erfindung

Die Erfindung bezieht sich auf eine Filterschaltung zur Unterdrückung einer Signalverzerrung und ein zugehöriges Verfahren zur Unterdrückung einer Signalverzerrung

### Hintergrund der Erfindung

Der Signalpfad eines Empfängers ist an eine Signalquelle gekoppelt. Der Arbeitspunkt dieser Signalquelle ist oft nicht der gleiche, die der Empfänger benötigt. Zum Beispiel wird eine Antenne häufig auf Masseniveau betrieben, oder eine Photomultiplier Tube (PMT) bei ca. 2000V. Daher wird ein Hochpass eingesetzt, um die Arbeitspunkte zu trennen. Dieser Hochpass ist im Prinzip eine Kapazität. Wenn auf einer Seite der Kapazität ein Tiefpass angebracht ist, um einen Arbeitspunkt vorzugeben, spricht man auch von einem Bias Tee. Eine solche Anordnung ist anfällig für Signalverzerrungen.

Aus der WO 9310553 A1 ist ein Verfahren bekannt, welches die Nichtlinearität eines Photodetektors korrigiert, ohne den Rauschpegel im Detektorsignal zu erhöhen. Der Detektor ist mit einem Vorverstärker gekoppelt, der durch das Fehlen einer positiven Rückkopplung gekennzeichnet ist, und das Vorverstärkersignal wird an einen linearen Verstärker weitergeleitet, dessen Ausgangssignal dann digitalisiert wird. Das digitalisierte Signal wird dann entsprechend einer gespeicherten Kalibrierungsinformation transformiert, die für die nichtlineare Charakteristik des Photodetektors repräsentativ ist.

### Zusammenfassung der Erfindung

Es ist eine Aufgabe der vorliegenden Erfindung, eine verbesserte Filterschaltung zur Verfügung zu stellen.

Gemäß eines ersten Aspektes der Erfindung wird eine Filterschaltung zur Unterdrückung einer Signalverzerrung zur Verfügung gestellt. Die Filterschaltung umfasst, einen Stromspannungswandler, eine Frequenzweiche und eine Kompensationsschaltungsanordnung. Die Frequenzweiche weist mindestens einen Eingang für eine Signalquelle, einen ersten Ausgang und einen zweiten Ausgang auf. Der Eingang der Frequenzweiche weist in einem ersten Frequenzband eine erste Impedanz und in einem zweiten Frequenzband eine zweite Impedanz auf. Das zweite Frequenzband weist höhere Frequenzen als das erste Frequenzband auf. Der erste Ausgang weist im ersten Frequenzband eine dritte Impedanz und im zweiten Frequenzband eine vierte Impedanz auf, und der Absolutbetrag der vierten Impedanz ist größer oder gleich als der Absolutbetrag der dritten Impedanz. Der zweite Ausgang weist im ersten Frequenzband eine fünfte Impedanz und im zweiten Frequenzband eine sechste Impedanz auf, und der Absolutbetrag der fünften Impedanz ist größer als der Absolutbetrag der sechsten Impedanz. Ein Eingang des Stromspannungswandlers ist an den zweiten Ausgang der Frequenzweiche angeschlossen. Die Kompensationsschaltungsanordnung ist eingerichtet, einen ersten Signalstrom zwischen dem Eingang und erstem Ausgang der Frequenzweiche zu detektieren. Der Signalstrom erzeugt einen Verzerrungsstrom zwischen dem Eingang des Stromspannungswandlers und dem zweiten Ausgang der Frequenzweiche. Die Kompensationsschaltungsanordnung ist weiter so eingerichtet, einen Kompensationsstrom innerhalb des Stromspannungswandlers so einzukoppeln, dass der Kompensationsstrom dem Verzerrungsstrom entgegengesetzt und gleich groß ist und dadurch den Verzerrungsstrom so zu kompensieren, dass ein verzerrungsfreies Ausgangssignal am Ausgang des Stromspannungswandlers zur Verfügung gestellt wird.

Der Begriff "verzerrungsfreies Ausgangssignal" ist dabei so zu verstehen, dass die Störung durch den Verzerrungsstrom zum Beispiel für einen Empfänger der das verzerrungsfreie Ausgangssignal zur Weiterverarbeitung empfängt im Wesentlichen nicht mehr von Relevanz ist. Die Verzerrung wird somit auf Hardwareebene reduziert, vorzugsweise komplett unterdrückt, sodass eine aufwändige Nachbearbeitung des Ausgangssignals der Filterschaltung im Wesentlichen vermieden werden kann. Der Signalstrom kann am Eingang und auch am ersten Ausgang der Frequenzweiche detektiert werden. Die Filterschaltung findet insbesondere Anwendungen in hochwertigen Detektoren oder zum Beispiel als integrierte Schaltung auf Detektorchips.

Die Kompensationsschaltungsanordnung ist in einer Ausführungsform zwischen dem Eingang der Frequenzweiche und dem zweiten Ausgang der Frequenzweiche angeschlossen. Der Anschluss der Kompensationsschaltungsanordnung erfolgt somit von einer Signalquelle aus gesehen, von der der Signalstrom ausgeht, zwischen den Impedanzen, die den ersten und zweiten Ausgang der Frequenzweiche definieren. Es wird somit im Wesentlichen ein Spannungssignal am Eingang der Frequenzweiche zur Steuerung der Kompensationsschaltungsanordnung verwendet. Ein Kompensationssignal zur Kompensation des Verzerrungsstroms, dass durch die Kompensationsschaltungsanordnung erzeugt wird, wird dabei vorzugsweise zwischen dem zweiten Ausgang der Frequenzweiche und dem Eingang des Stromspannungswandlers eingekoppelt.

Die Kompensationsschaltungsanordnung ist in einer weiteren Ausführungsform am ersten Ausgang der Frequenzweiche angeschlossen. Der Anschluss der Kompensationsschaltungsanordnung erfolgt somit von einer Signalquelle aus gesehen, von der der Signalstrom ausgeht, hinter der oder den Impedanzen, die den ersten Ausgang der Frequenzweiche definieren. Es wird somit im Wesentlichen ein Stromsignal am ersten Ausgang der Frequenzweiche zur Steuerung der Kompensationsschaltungsanordnung verwendet. Ein Kompensationssignal zur Kompensation des Verzerrungsstroms, dass durch die Kompensationsschaltungsanordnung erzeugt wird, wird dabei vorzugsweise am Ausgang des Stromspannungswandlers eingekoppelt.

Die Frequenzweiche weist vorzugsweise einen ersten ohmschen Widerstand im ersten Ausgang und einen ersten Kondensator im zweiten Ausgang auf, wobei der erste ohmsche Widerstand größer ist als ein Leitungswiderstand im Eingang der Frequenzweiche. Der Aufbau der Frequenzweiche stellt in dieser Ausführungsform im Wesentlichen eine sehr einfache Form einer Frequenzweiche dar. Alternative Ausführungsformen, die weitere passive Komponenten aufweisen, könnten verwendet werden.

Die Kompensationsschaltungsanordnung ist, wie bereits oben angedeutet, in einer Ausführungsform dazu eingerichtet, eine Signalspannung am Eingang der Frequenzweiche in einen Kompensationsstrom zu wandeln. Die Kompensationsschaltungsanordnung ist dabei so eingerichtet, dass der Kompensationsstrom dem Verzerrungsstrom entgegengesetzt und möglichst gleich groß ist, und, zum Beispiel bei Einkopplung zwischen dem zweiten Ausgang der Frequenzweiche und dem Eingang des Stromspannungswandler, den Verzerrungsstrom im Wesentlichen kompensiert.

Die Kompensationsschaltungsanordnung weist in einer Ausführungsform einen zweiten Kondensator auf. Der zweite Kondensator ist an einen hochohmigen Verstärker angeschlossen, um die Signalspannung an den hochohmigen Verstärker weiterzuleiten. Der hochohmigen Verstärker ist dabei eingerichtet, die Signalspannung in den Kompensationsstrom zu wandeln. Hochohmiger Verstärker heißt, dass das Signal am Eingang zur Frequenzweiche durch den Verstärker nicht beeinflusst wird oder im Wesentlichen nicht beeinflusst wird. Der zweite Kondensator zur Einkopplung des hochfrequenten Störsignals in den hochohmigen Verstärker weist dabei vorzugsweise die gleiche Kapazität auf wie der erste Kondensator. Der Kompensationsstrom wird vorzugsweise über einen zweiten ohmschen Widerstand mit der dem Stromspannungswandler zugewandten Seite des ersten Kondensators verbunden. Der zweite ohmsche Widerstand ist vorzugsweise genauso groß ist wie der erste ohmsche Widerstand.

Eine weitere Ausführungsform der Filterschaltung weist eine Kompensationsschaltungsanordnung mit einem Stromsensor auf. Der Stromsensor ist vorzugsweise eingerichtet, einen Strom zu detektieren, der über den ersten ohmschen Widerstand fließt. Der Stromsensor ist vorzugsweiseweiter eingerichtet, eine regelbare Stromquelle so zu steuern, dass ein durch den Verzerrungsstrom verzerrtes Signal am Ausgang des Stromspannungswandlers kompensiert wird. Die Kompensationsschaltungsanordnung weist dabei vorzugsweise einen zweiten ohmschen Widerstand zwischen dem Ausgang des Stromspannungswandlers und der steuerbaren Stromquelle auf, so dass das verzerrte Signal zwischen der regelbaren Stromquelle und dem zweiten ohmschen Widerstand kompensiert wird.

Es ist eine weitere Aufgabe der vorliegenden Erfindung, einen verbesserten Signalempfänger zur Verfügung zu stellen.

Der Signalempfänger umfasst einen Empfänger und eine Filterschaltung, wie sie zuvor beschrieben wurde. Der Empfänger ist eingerichtet, ein Signal über die Filterschaltung zu empfangen.

Es ist eine weitere Aufgabe der vorliegenden Erfindung, einen verbesserten Signalanalysator zur Verfügung zu stellen.

Der Signalanalysator umfasst einen Signalempfänger, wie zuvor beschrieben und eine Analyseeinheit. Die Analyseeinheit ist eingerichtet, das mittels des Empfängers empfangene Signal zu analysieren.

Es ist eine weitere Aufgabe der vorliegenden Erfindung, ein verbessertes Verfahren zur Unterdrückung einer Signalverzerrung zur Verfügung zu stellen. Das Verfahren umfasst die Schritte:
- erzeugen eines Verzerrungsstroms zwischen einem Eingang eines Stromspannungswandlers und einem zweiten Ausgang einer Frequenzweiche durch einen ersten Signalstrom zwischen einem Eingang für eine Signalquelle und einem erstem Ausgang der Frequenzweiche, wobei ein Eingang des Stromspannungswandlers an den zweiten Ausgang der Frequenzweiche angeschlossen ist,
- detektieren des ersten Signalstroms, wobei die Frequenzweiche mindestens den Eingang, den ersten Ausgang und den zweiten Ausgang aufweist, wobei der Eingang in einem ersten Frequenzband eine erste Impedanz und in einem zweiten Frequenzband eine zweite Impedanz aufweist und das zweite Frequenzband höhere Frequenzen als das erste Frequenzband aufweist, wobei der erste Ausgang im ersten Frequenzband eine dritte Impedanz und im zweiten Frequenzband eine vierte Impedanz aufweist, und der Absolutbetrag der vierten Impedanz größer oder gleich ist als der Absolutbetrag der dritten Impedanz, wobei der zweite Ausgang im ersten Frequenzband eine fünfte Impedanz und im zweiten Frequenzband eine sechste Impedanz aufweist, und der Absolutbetrag der fünften Impedanz größer ist als der Absolutbetrag der sechsten Impedanz,
- kompensieren des Verzerrungsstroms durch Einkoppeln eines Kompensationsstroms innerhalb des Stromspannungswandlers (300), wobei der Kompensationsstrom dem Verzerrungsstrom entgegengesetzt und gleich groß ist.

Die einzelnen Schritte des Verfahrens müssen nicht notwendigerweise in der angegebenen Reihenfolge durchgeführt werden.

Es wird klargestellt, dass die Filterschaltung gemäß Anspruch 1, der Signalempfänger gemäß Anspruch 12 und das Verfahren gemäß Anspruch 14 ähnliche und/oder identische Ausführungsform aufweisen, wie sie insbesondere in den abhängigen Ansprüchen beschrieben werden.

Es wird weiterhin klargestellt, dass bevorzugte Ausführungsformen der Erfindung auch jede Kombination der abhängigen Ansprüche mit dem entsprechenden unabhängigen Anspruch darstellen.

Weitere bevorzugte Ausführungsformen werden im Folgenden beschrieben.

### Kurze Beschreibung der Abbildungen

Diese und andere Aspekte der Erfindung werden im Detail in den Abbildungen wie folgt gezeigt.
Fig. 1 zeigt eine Prinzipskizze einer Signalquelle die über einen Hochpass mit einem Empfänger gekoppelt ist
Fig. 2 zeigt einen Graphen mit verschiedenen Strömen der in Fig. 1 gezeigten Anordnung
Fig. 3 zeigt einen Graphen mit verschiedenen Spannungen der in Fig. 1 gezeigten Anordnung
Fig. 4 zeigt eine Prinzipskizze einer Signalquelle die über eine erste Filterschaltung mit einem Empfänger gekoppelt ist
Fig. 5 zeigt einen Graphen mit verschiedenen Strömen der in Fig. 4 gezeigten Anordnung
Fig. 6 zeigt einen Graphen mit verschiedenen Spannungen der in Fig. 4 gezeigten Anordnung
Fig. 7 zeigt eine Prinzipskizze einer Signalquelle die über eine zweite Filterschaltung mit einem Empfänger gekoppelt ist Fig. 8 zeigt eine Prinzipskizze eines Signalanalysators
Fig. 9 zeigt eine Prinzipskizze eines Verfahrens zur Unterdrückung einer Signalverzerrung

### Detaillierte Beschreibung der Ausführungsbeispiele

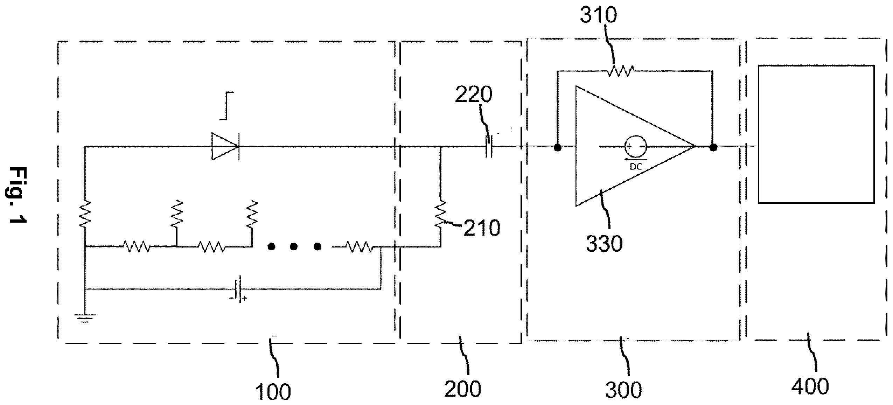

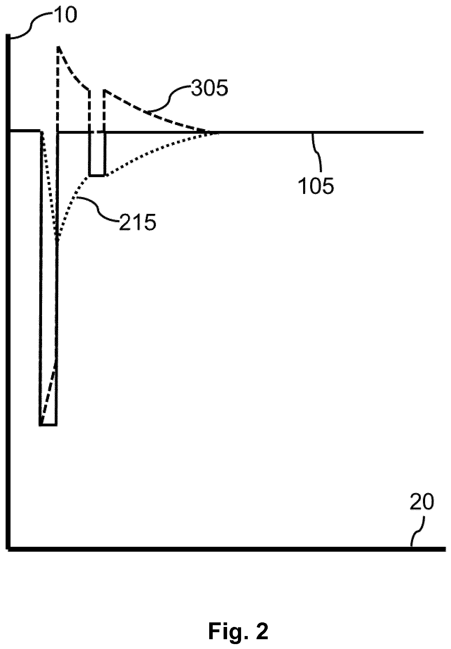

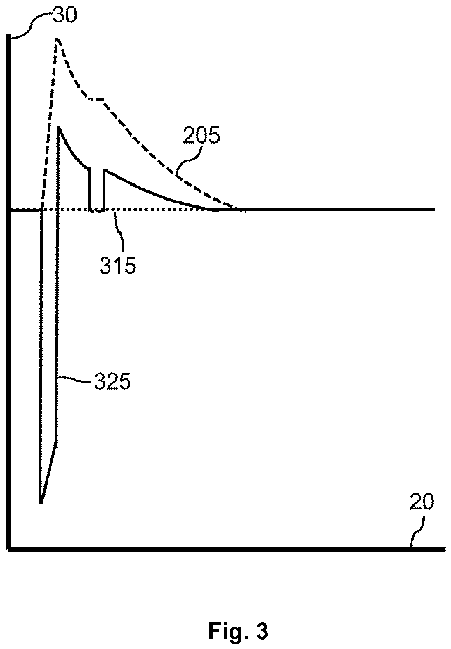

Fig. 1 zeigt eine Prinzipskizze einer Signalquelle 100, die über einen Hochpass mit einem Empfänger 400 gekoppelt ist. Die Signalquelle 100 ist im vorliegenden Fall ein Photomultiplier. Der Hochpass umfasst eine Frequenzweiche 200 und einen Stromspannungswandler 300. Die Frequenzweiche 200 ist als Bias Tee ausgeführt mit einem ersten Kondensator 220 zwischen einem Eingang der Frequenzweiche 200 und einem zweiten Ausgang und einem ersten ohmschen Widerstand 210 zwischen dem Eingang und einem ersten Ausgang der Frequenzweiche 200. Der zweite Ausgang der Frequenzweiche 200 ist mit einem Eingang des Stromspannungswandler 300 verbunden, wobei der Stromspannungswandler 300 als Transimpedanzverstärker 330 mit einem Transimpedanzwiderstand 310 ausgeführt ist, wobei ein Ausgang des Transimpedanzverstärkers 330 über den Transimpedanzwiderstand 330 mit dem Eingang des Transimpedanzverstärkers 330 rück- oder gegengekoppelt ist. Andere Implementierungen des Transimpedanzverstärkers sind auch möglich. Das Signal 325 am Ausgang des Transimpedanzverstärkers 330 wird an den Empfänger 400 weitergeleitet. Der Transimpedanzverstärker 330 regelt die Seite des ersten Kondensators 220 so, dass die Spannung sich kaum ändert (virtuelle Masse). Die Hochspannungseite ist dagegen hochohmig durch den ersten ohmschen Widerstand 210 des Bias Tees. Die Ladung auf der vom Transimpedanzverstärker 330 abgewandten Seite des ersten Kondensators 220 wird auf der dem Transimpedanzverstärker 330 zugewandten Seite des ersten Kondensators 220 ausgeglichen, und verzerrt daher das Signal 325, wie in den Figuren 2 und 3 weiter erläutert wird.

Fig. 2 zeigt einen Graphen mit verschiedenen Strömen der in Fig. 1 gezeigten Anordnung. Die y-Achse zeigt die Stromstärke 10 und die x-Achse die Zeit 20. Die Größe der Signale liegt bei einigen 100 mA und die Länge der Pulse liegt bei einigen Mikrosekunden. Der Signalstrom 105, der von der Signalquelle 100 ausgeht, weist in diesem Beispiel einen großen Puls auf, dem im kleinen zeitlichen Abstand ein kleiner Puls folgt. Beide Pulse sollen im Empfänger 400 unabhängig voneinander detektiert werden. Ein erster Signalstrom 215, der über den ersten ohmschen Widerstand 210 fließt, erzeugt eine Ladungsverschiebung auf der dem Transimpedanzverstärker 330 zugewandten Seite des ersten Kondensators 220. Mit dieser Ladungsverschiebung geht ein Verzerrungsstrom einher, der sich mit dem Signalstrom 105 überlagert und ein verzerrtes Stromsignal 305 erzeugt.

Fig. 3 zeigt einen Graphen mit verschiedenen Spannungen der in Fig. 1 gezeigten Anordnung. Die y-Achse zeigt die Spannung 30 und die x-Achse die Zeit 20. Der Graph zeigt die Spannung am Eingang des Transimpedanzverstärkers 315, die im Wesentlichen konstant ist. Die Signalspannung 205 am Eingang der Frequenzweiche 200 (Bias Tee), welche der Signalquelle 100 (Photomultiplier) zugewandt ist, steigt mit Beginn des großen Pulses stark an und fällt anschließend bis zu Beginn des kleinen Pulses ab, verharrt für die Dauer des kleinen Pulses auf nahezu konstanten Level um nach Ende des kleinen Pulses schließlich wieder innerhalb von einigen Mikrosekunden auf 0 abzufallen. Der zeitliche Verlauf der Spannung am Ausgang des Transimpedanzverstärkers, also das Signal 325, welches an den Empfänger 400 weitergeleitet wird, weist die gleiche Form auf wie das verzerrte Stromsignal 305. Das Signal 325 wird somit durch den Verzerrungsstrom verzerrt.

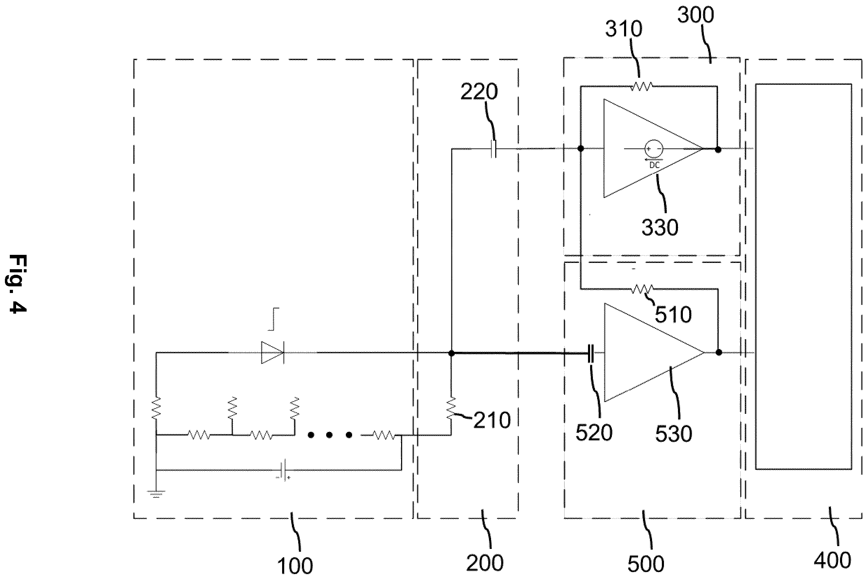

Fig. 4 zeigt eine Prinzipskizze einer Signalquelle 100, die über eine erste Filterschaltung mit einem Empfänger 400 gekoppelt ist. Die Signalquelle 100 ist im vorliegenden Fall ein Photomultiplier. Die Filterschaltung umfasst eine Frequenzweiche 200, einen Stromspannungswandler 300 und eine Kompensationsschaltungsanordnung 500. Die Frequenzweiche 200 ist als Bias Tee ausgeführt mit einem ersten Kondensator 220 zwischen einem Eingang der Frequenzweiche 200 und einem zweiten Ausgang und einem ersten ohmschen Widerstand 210 zwischen dem Eingang und einem ersten Ausgang der Frequenzweiche 200. Der zweite Ausgang der Frequenzweiche 200 ist mit einem Eingang des Stromspannungswandler 300 verbunden, wobei der Stromspannungswandler 300 als Transimpedanzverstärker 330 mit einem Transimpedanzwiderstand 310 ausgeführt ist, wobei ein Ausgang des Transimpedanzverstärkers 330 über den Transimpedanzwiderstand 330 mit dem Eingang des Transimpedanzverstärkers 330 rückgekoppelt ist. Das Signal 325a am Ausgang des Transimpedanzverstärkers 330 wird an den Empfänger 400 weitergeleitet. Der Transimpedanzverstärker 330 regelt die Seite des ersten Kondensators 220 so, dass sich die Spannung kaum ändert (virtuelle Masse). Die Hochspannungseite ist dagegen hochohmig durch den ersten ohmschen Widerstand 210 des Bias Tees. Die Ladung auf der vom Transimpedanzverstärker 330 abgewandten Seite des ersten Kondensators 220 wird auf der dem Transimpedanzverstärker 330 zugewandten Seite des ersten Kondensators 220 ausgeglichen. Der Eingang der Frequenzweiche 200 (Bias Tee) ist zudem über einen zweiten Kondensator 520 der Kompensationsschaltungsanordnung 500 mit einem Eingang eines hochohmigen Verstärkers 530 der Kompensationsschaltungsanordnung 500 verbunden. Die Kapazität des zweiten Kondensators 520 ist in diesem Ausführungsbeispiel gleich groß gewählt wie die Kapazität des ersten Kondensators 220. Ein Ausgang des hochohmigen Verstärkers 530 ist über einen zweiten ohmschen Widerstand 510 der Kompensationsschaltungsanordnung 500 mit der dem Eingang des Transimpedanzverstärkers zugewandten Seite des Kondensators 220 verbunden. Der zweite ohmsche Widerstand 510 hat die gleiche Größe wie der erste ohmsche Widerstand 210. Durch den zweiten Kondensator 520, wird die Signalspannung 205a am Eingang der Frequenzweiche 200 an den hochohmigen Verstärker 530 geführt. Die Signalspannung 205a wird durch den hochohmigen Verstärker 530 in einen Strom gewandelt, der als Kompensationsstrom 515 die Ladungsverschiebung auf der dem Transimpedanzverstärker 330 zugewandten Seite des ersten Kondensators 220 kompensiert. Der Strom für die Ladungsverschiebung wird somit nicht mehr durch den Transimpedanzverstärker 330 zur Verfügung gestellt, so dass das Signal 325a nicht mehr verzerrt wird. Die Kapazität des zweiten Kondensators 520 und der Wert des zweiten Widerstands 510 können in Abhängigkeit von zusätzlichen Bauteilen, die an den hochohmigen Verstärker 530 angeschlossen werden, angepasst werden. Es ist somit nicht zwingend dass die Kapazität des zweiten Kondensators 520 und der Widerstand des zweiten Widerstands 510 identisch sind mit der Kapazität des ersten Kondensators 220 und des ersten Widerstands 210. Solche zusätzlichen Bauteile können zum Beispiel verwendet werden oder erforderlich sein, um nicht ideales Verhalten des hochohmigen Verstärkers 530 zu kompensieren.

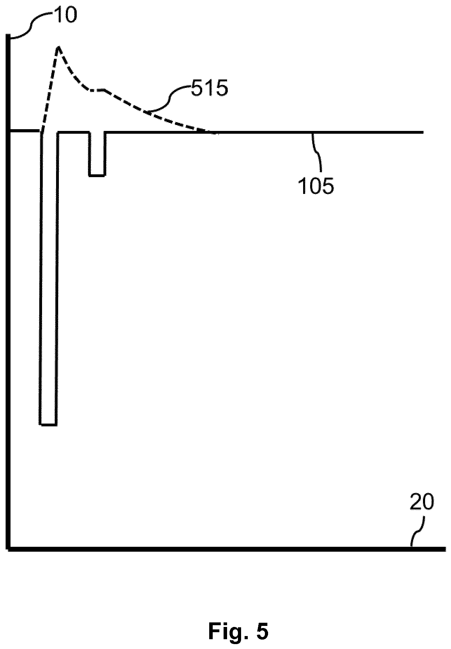

Fig. 5 zeigt einen Graphen mit verschiedenen Strömen der in Fig. 4 gezeigten Anordnung. Die y-Achse zeigt die Stromstärke 10 und die x-Achse die Zeit 20. Die Größe der Signale liegt bei einigen 100 mA und die Länge der Pulse liegt bei einigen Mikrosekunden. Der Signalstrom 105, der von der Signalquelle 100 ausgeht, weist in diesem Beispiel wieder einen großen Puls auf, dem im kleinen zeitlichen Abstand ein kleiner Puls folgt. Beide Pulse sollen im Empfänger 400 unabhängig voneinander detektiert werden. Der erste in Fig. 2 gezeigte Signalstrom 215, der über den ersten ohmschen Widerstand 210 fließt, erzeugt eine Ladungsverschiebung auf der dem Transimpedanzverstärker 330 zugewandten Seite des ersten Kondensators 220. Mit dieser Ladungsverschiebung geht ein Verzerrungsstrom einher. Die Kompensationsschaltungsanordnung 500 erzeugt nun den Kompensationsstrom 515, der dem Verzerrungsstrom entgegengesetzt ist und diesen kompensiert. Der Signalstrom 105 wird somit nicht verzerrt.

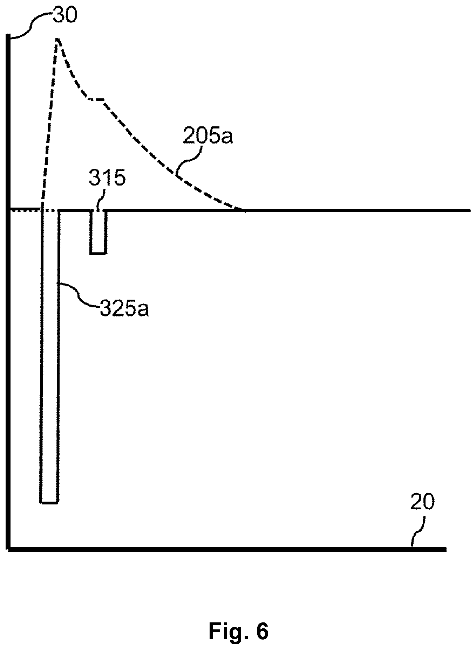

Fig. 6 zeigt einen Graphen mit verschiedenen Spannungen der in Fig. 4 gezeigten Anordnung. Die y-Achse zeigt die Spannung 30 und die x-Achse die Zeit 20. Der Graph zeigt die Spannung am Eingang des Transimpedanzverstärkers 315, die wieder im Wesentlichen konstant ist. Die Signalspannung 205a am Eingang der Frequenzweiche 200 (Bias Tee), welche der Signalquelle 100 (Photomultiplier) zugewandt ist, steigt mit Beginn des großen Pulses stark an und fällt anschließend bis zu Beginn des kleinen Pulses ab, verharrt für die Dauer des kleinen Pulses auf nahezu konstanten Level um nach Ende des kleinen Pulses schließlich wieder innerhalb von einigen Mikrosekunden auf 0 abzufallen. Der zeitliche Verlauf der Spannung am Ausgang des Transimpedanzverstärkers, also das Signal 325a, welches an den Empfänger 400 weitergeleitet wird, weist die gleiche Form auf wie der Signalstrom 105. Die Verzerrung durch den Verzerrungsstrom wird somit durch den Kompensationsstrom 515 kompensiert, so dass der große und auch der zeitlich nachfolgende kleine Puls im Empfänger ohne aufwändige Signalnachbearbeitung detektiert werden können.

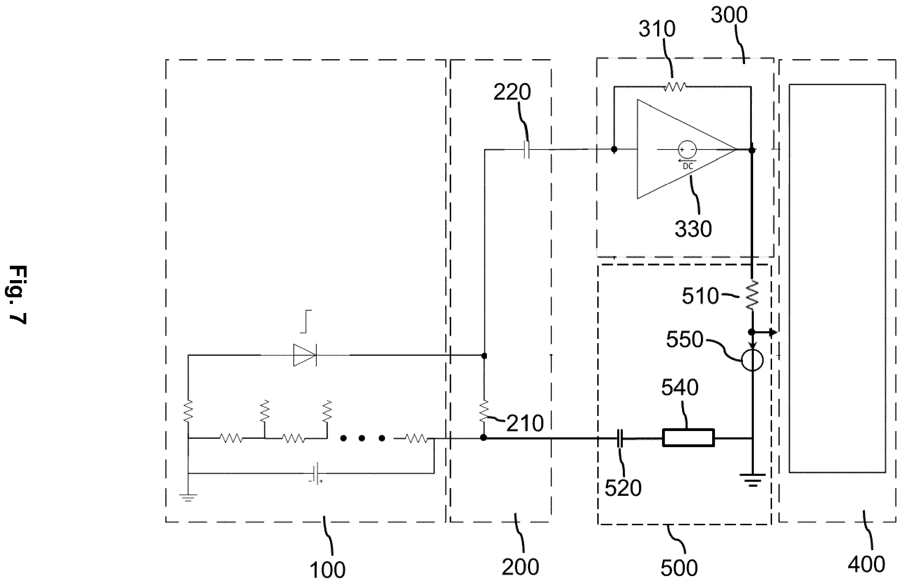

Fig. 7 zeigt eine Prinzipskizze einer Signalquelle 100, die über eine zweite Filterschaltung mit einem Empfänger 400 gekoppelt ist. Die Signalquelle 100 ist im vorliegenden Fall ein Photomultiplier. Der Filterschaltung umfasst eine Frequenzweiche 200, einen Stromspannungswandler 300 und eine Kompensationsschaltungsanordnung 500. Die Frequenzweiche 200 ist als Bias Tee ausgeführt mit einem ersten Kondensator 220 zwischen einem Eingang der Frequenzweiche 200 und einem zweiten Ausgang und einem ersten ohmschen Widerstand 210 zwischen dem Eingang und einem ersten Ausgang der Frequenzweiche 200. Der zweite Ausgang der Frequenzweiche 200 ist mit einem Eingang des Stromspannungswandler 300 verbunden, wobei der Stromspannungswandler 300 als Transimpedanzverstärker 330 mit einem Transimpedanzwiderstand 310 ausgeführt ist, wobei ein Ausgang des Transimpedanzverstärkers 330 über den Transimpedanzwiderstand 330 mit dem Eingang des Transimpedanzverstärkers 330 rückgekoppelt ist. Das Signal am Ausgang des Transimpedanzverstärkers 330 wird über einen zweiten ohmschen Widerstand 510 der Kompensationsschaltungsanordnung 500 an den Empfänger 400 weitergeleitet. Der Transimpedanzverstärker 330 regelt die Seite des ersten Kondensators 220 so, dass die Spannung sich kaum ändert (virtuelle Masse). Die Hochspannungseite ist dagegen hochohmig durch den ersten ohmschen Widerstand 210 des Bias Tees. Die Ladung auf der vom Transimpedanzverstärker 330 abgewandten Seite des ersten Kondensators 220 wird auf der dem Transimpedanzverstärker 330 zugewandten Seite des ersten Kondensators 220 durch den Transimpedanzverstärker 330 ausgeglichen. Das Ausgangssignal des Transimpedanzverstärkers ist somit, wie im Zusammenhang mit Fig. 1 diskutiert, gestört. Der erste Ausgang der Frequenzweiche 200 (Bias Tee) ist über einen zweiten Kondensator 520 mit der Kompensationsschaltungsanordnung 500 mit einem Eingangswiderstand 540 eines Stromsensors verbunden. Der Eingangswiderstand 540 ist dabei kleiner als der erste ohmsche Widerstand 210, um den Stromfluss über den ersten Widerstand 210 so wenig wie möglich zu beeinflussen. Der Strom über den Eingangswiderstand 540 wird nun als Regelstrom zur Regelung der regelbaren Stromquelle 550 benutzt. Die regelbare Stromquelle 550 verstärkt den Regelstrom, so dass dieser das gestörte Signal des Ausgangs des Transimpedanzverstärkers 330 aus Sicht der regelbaren Stromquelle 550 vor dem zweiten ohmschen Widerstand 510 spannungsmäßig kompensiert wird, so dass das Signal 325a, das an den Empfänger 400 weitergeleitet wird, nicht mehr verzerrt ist. Der zweite ohmsche Widerstand 510 ist dabei vorzugsweise kleiner als der der erste ohmsche Widerstand 210 und weist in einer besonders bevorzugten Ausführungsform eine Größe auf, die der Differenz zwischen dem ersten ohmschen Widerstand 210 und dem Transimpedanzwiderstand 310 entspricht. Eine mögliche Ausführungsform für die regelbare Stromquelle 550 in Kombination mit dem niederhochohmigen Eingangswiderstand 540 wäre zum Beispiel ein Stromspiegel, der den Regelstrom mittels eines angepassten Spiegelfaktors verstärkt und einen Kompensationsstrom zur Kompensation der Störung auf dem Ausgangssignal des Transimpedanzverstärkers 330 zur Verfügung stellt. Die Kapazität des zweiten Kondensators 520 und der Wert des zweiten Widerstands 510 können in Abhängigkeit von zusätzlichen Bauteilen, die an den Stromsensor angeschlossen werden, angepasst werden. Die Kapazität des zweiten Kondensators 520 und der Widerstand des zweiten Widerstands 510 werden in Abhängigkeit von der konkreten Ausführung des Stromsensors gewählt, wobei gegebenenfalls das reale Verhalten der verwendeten Bauteile kompensiert werden muss.

Im Gegensatz zur Schaltung in der Fig. 4 wird in der Schaltung in Fig. 7 nicht das Signal am Eingang des Transimpedanzverstärkers 330 korrigiert oder kompensiert sondern das Signal am Ausgang des Transimpedanzverstärkers 330. Es kann somit wahlweise das Spannungssignal am Eingang der Frequenzweiche 200 oder das Stromsignal am ersten Ausgang der Frequenzweiche 200 als Steuersignal zur Kompensation verwendet werden. Die Einspeisung des mittels des Steuersignals erzeugten Korrektursignals kann an einer beliebigen Stelle zwischen dem Eingang und dem Ausgang des Transimpedanzverstärkers 330 erfolgen. Es muss lediglich bekannt sein, wie das gestörte Signal am Eingang des Transimpedanzverstärkers 330 an einem definierten Punkt innerhalb der Schaltung des Transimpedanzverstärkers 330 transformiert wurde. Mit diesem Wissen lässt sich bestimmen, welche Schaltung erforderlich ist um das Steuersignal zur Kompensation der Störung an diesem definierten Punkt zu verwenden.

Der Tranzimpedanzwiderstand 310 wird im Wesentlichen durch die Versorgungsspannung und Stromstärke des Signals bestimmt. Beide hängen von der jeweiligen Anwendung ab, so dass sich der konkrete Wert des Tranzimpedanzwiderstands 310 in Abhängigkeit von der jeweiligen Anwendung berechnen lässt. Die konkreten Werte des ersten ohmschen Widerstands 210, des zweiten ohmschen Widerstands 510, des ersten Kondensators 220 und des zweiten Kondensators 520 hängen insbesondere von der Frequenz des Signals ab. Die Frequenz des Signals hängt ebenfalls von der jeweiligen Anwendung ab, so dass sich die Werte in Abhängigkeit von der jeweiligen Anwendung berechnen lassen.

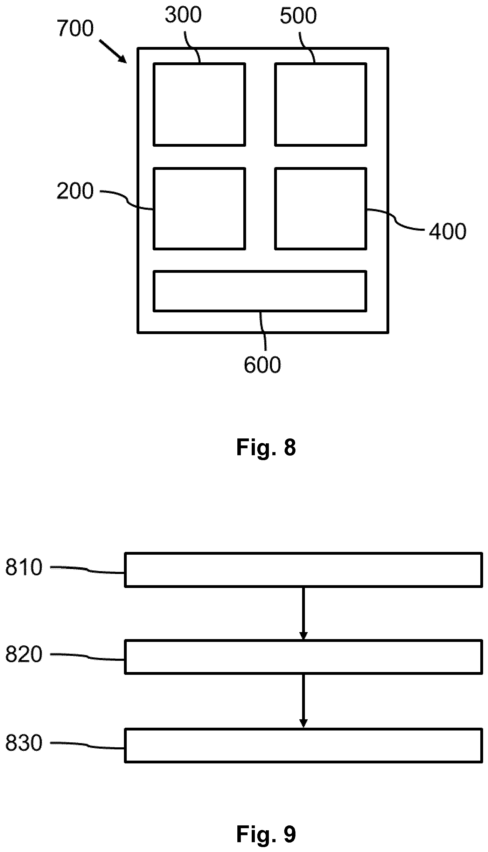

Fig. 8 zeigt eine Prinzipskizze eines Signalanalysators 700. Der Signalanalysator 700 umfassend einen Signalempfänger und eine Analyseeinheit 600. Der Signalempfänger umfasst einen Empfänger 400 und eine Filterschaltung, wie sie zum Beispiel im Zusammenhang mit der Figur 4 beschrieben ist. Der Empfänger ist eingerichtet, ein Signal 325a über die Filterschaltung zu empfangen. Die Analyseeinheit 600 ist eingerichtet, das Signal 325a zu analysieren. Die Analyseeinheit 600 kann einen oder mehrere Mikroprozessoren, Prozessoren usw., einen oder mehrere Speicherelemente oder Speicherbausteine zur Speicherung und Verarbeitung von Daten bzw. Signalen aufweisen.

Fig. 9 zeigt eine Prinzipskizze eines Verfahrens zur Unterdrückung einer Signalverzerrung. In Schritt 810 wird ein Verzerrungsstroms zwischen einem Eingang eines Stromspannungswandlers 300 und einem zweiten Ausgang einer Frequenzweiche 200 durch einen ersten Signalstrom zwischen einem Eingang und einem erstem Ausgang der Frequenzweiche 200 erzeugt. Ein Eingang des Stromspannungswandlers 300 ist dabei an den zweiten Ausgang der Frequenzweiche 200 angeschlossen. In Schritt 820 wird der erste Signalstrom detektiert. Die Frequenzweiche 200 weist mindestens den Eingang, den ersten Ausgang und den zweiten Ausgang auf. Der Eingang der Frequenzweiche 200 weist in einem ersten Frequenzband eine erste Impedanz und in einem zweiten Frequenzband eine zweite Impedanz auf. Das zweite Frequenzband weist höhere Frequenzen als das erste Frequenzband auf. Der erste Ausgang weist im ersten Frequenzband eine dritte Impedanz und im zweiten Frequenzband eine vierte Impedanz auf, und der Absolutbetrag der vierten Impedanz ist größer als der Absolutbetrag der dritten Impedanz. Der zweite Ausgang weist im ersten Frequenzband eine fünfte Impedanz und im zweiten Frequenzband eine sechste Impedanz auf, und der Absolutbetrag der fünften Impedanz ist größer als der Absolutbetrag der sechsten Impedanz. In Schritt 830 wird der Verzerrungsstrom kompensiert.

Es ist eine Idee der vorliegenden Erfindung mit einer Filterschaltung zu verhindern, dass Ladungsverschiebungen, die durch einen oder mehrere Ströme in einer Frequenzweiche 200 verursacht werden, ein Störsignal erzeugen, welches ansonsten durch aufwendige Signalnachbearbeitung entfernt werden müsste. Der Spannungsverlauf am Eingang der Frequenzweiche 200 oder der Strom am zweiten Ausgang der Frequenzweiche 200 werden dabei dazu verwendet, um mittels einer Kompensationsschaltungsanordnung ein Kompensationssignal zu generieren, welches das durch die Ladungsverschiebungen verursachte Störsignal im Wesentlichen kompensiert. Die Kompensation kann dabei in Abhängigkeit vom Aufbau des Stromspannungswandlers 300 an einer beliebigen aber definierten Stelle zwischen dem Eingang und dem Ausgang des Stromspannungswandlers 300 erfolgen.

Weitere Varianten der Erfindung und ihre Ausführung ergeben sich für den Fachmann aus der vorangegangenen Offenbarung, den Figuren und den Patentansprüchen, soweit im Umfang der Patentansprüche enthalten.

In den Patentansprüchen angegebene Bezugszeichen sind nicht als Beschränkungen der eingesetzten Mittel und Schritte anzusehen.

### Liste der Bezugszeichen

- 10: Stromstärke
- 20: Zeit
- 30: Spannung
- 100: Signalquelle
- 105: Signalstrom
- 200: Frequenzweiche
- 205,205a: Signalspannung
- 210: erster ohmscher Widerstand
- 215: erster Signalstrom
- 220: erster Kondensator
- 300: Stromspannungswandler
- 305: verzerrtes Stromsignal
- 310: Transimpedanzwiderstand
- 315: Spannung am Eingang des Transimpedanzverstärkers
- 325,325a: Signal
- 330: Transimpedanzverstärker
- 400: Empfänger
- 500: Kompensationsschaltungsanordnung
- 510: zweiter ohmscher Widerstand
- 515: Kompensationsstrom
- 520: zweiter Kondensator
- 530: hochohmiger Verstärker
- 540: Eingangswiderstand Stromsensor
- 550: regelbare Stromquelle
- 600: Analyseeinheit
- 700: Signalanalysator
- 810: erzeugen des Verzerrungsstroms
- 820: detektieren des ersten Signalstroms
- 830: kompensieren des Verzerrungsstroms

## Patentansprüche

1. Eine Filterschaltung zur Unterdrückung einer Signalverzerrung umfassend, einen Stromspannungswandler (300), eine Frequenzweiche (200) und eine Kompensationsschaltungsanordnung (500), wobei die Frequenzweiche (200) mindestens einen Eingang für eine Signalquelle (100), einen ersten Ausgang und einen zweiten Ausgang aufweist, wobei der Eingang der Frequenzweiche (200) in einem ersten Frequenzband eine erste Impedanz und in einem zweiten Frequenzband eine zweite Impedanz aufweist und das zweite Frequenzband höhere Frequenzen als das erste Frequenzband aufweist, wobei der erste Ausgang im ersten Frequenzband eine dritte Impedanz und im zweiten Frequenzband eine vierte Impedanz aufweist, und der Absolutbetrag der vierten Impedanz größer oder gleich ist als der Absolutbetrag der dritten Impedanz, wobei der zweite Ausgang im ersten Frequenzband eine fünfte Impedanz und im zweiten Frequenzband eine sechste Impedanz aufweist, und der Absolutbetrag der fünften Impedanz größer ist als der Absolutbetrag der sechsten Impedanz, wobei ein Eingang des Stromspannungswandlers (300) an den zweiten Ausgang der Frequenzweiche (200) angeschlossen ist, wobei die Kompensationsschaltungsanordnung (500) eingerichtet ist, einen ersten Signalstrom zwischen dem Eingang und erstem Ausgang der Frequenzweiche (200) zu detektieren, wobei der Signalstrom einen Verzerrungsstrom zwischen dem Eingang des Stromspannungswandlers (300) und dem zweiten Ausgang der Frequenzweiche (200) erzeugt, **dadurch gekennzeichnet, dass** die Kompensationsschaltungsanordnung (500) eingerichtet ist, einen Kompensationsstrom innerhalb des Stromspannungswandlers so einzukoppeln, dass der Kompensationsstrom dem Verzerrungsstrom entgegengesetzt und gleich groß ist und dadurch den Verzerrungsstrom so zu kompensieren, dass ein verzerrungsfreies Ausgangssignal am Ausgang des Stromspannungswandlers (300) zur Verfügung gestellt wird.

2. Die Filterschaltung gemäß Anspruch 1, wobei die Kompensationsschaltungsanordnung (500) zwischen dem Eingang der Frequenzweiche (200) und dem zweiten Ausgang der Frequenzweiche (200) angeschlossen ist.

3. Die Filterschaltung gemäß Anspruch 1, wobei die Kompensationsschaltungsanordnung (500) am ersten Ausgang der Frequenzweiche (200) angeschlossen ist.

4. Die Filterschaltung gemäß einem der vorangehenden Ansprüche, wobei die Frequenzweiche (200) einen ersten ohmschen Widerstand (210) im ersten Ausgang aufweist und einen ersten Kondensator (220) im zweiten Ausgang aufweist, wobei der erste ohmsche Widerstand (210) größer ist als ein Leitungswiderstand im Eingang der Frequenzweiche (200).

5. Die Filterschaltung gemäß Anspruch 1, 2 oder 4, sofern Anspruch 4 von Anspruch 1 oder 2 abhängt, wobei die Kompensationsschaltungsanordnung (500) eingerichtet ist, eine Signalspannung (205, 205a) am Eingang der Frequenzweiche (200) in einen Kompensationsstrom (515) zu wandeln, und der Kompensationsstrom (515) angepasst ist, den Verzerrungsstrom zu kompensieren.

6. Die Filterschaltung gemäß Anspruch 5, wobei die Kompensationsschaltungsanordnung (500) einen zweiten Kondensator (520) aufweist, der zweite Kondensator (520) an einen hochohmigen Verstärker (530) angeschlossen ist, um die Signalspannung (205, 205a) an den hochohmigen Verstärker (530) weiterzuleiten, und der hochohmigen Verstärker (530) eingerichtet ist, die Signalspannung (205, 205a) in den Kompensationsstrom (515) zu wandeln.

7. Die Filterschaltung gemäß Anspruch 6, wobei der zweite Kondensator (520) die gleiche Kapazität aufweist wie der erste Kondensator (220).

8. Die Filterschaltung gemäß Anspruch 6 oder 7, wobei der Kompensationsstrom (515) über einen zweiten ohmschen Widerstand (510) mit dem ersten Kondensator (220) verbunden ist.

9. Die Filterschaltung gemäß Anspruch 8, wobei der zweite ohmsche Widerstand (510) genauso groß ist wie der erste ohmsche Widerstand (210).

10. Die Filterschaltung gemäß Anspruch 3, wobei die Kompensationsschaltungsanordnung (500) einen Stromsensor aufweist, wobei der Stromsensor eingerichtet ist, einen Strom über den ersten ohmschen Widerstand (210) zu detektieren, und der Stromsensor weiter eingerichtet ist eine regelbare Stromquelle (550) so zu steuern, dass ein durch den Verzerrungsstrom verzerrtes Signal am Ausgang des Stromspannungswandlers (300) kompensiert wird.

11. Die Filterschaltung gemäß Anspruch 10, wobei die Kompensationsschaltungsanordnung (500) einen zweiten ohmschen Widerstand (510) zwischen dem Ausgang des Stromspannungswandlers und der steuerbaren Stromquelle (550) aufweist, und das verzerrte Signal zwischen der regelbaren Stromquelle (550) und dem zweiten ohmschen Widerstand (510) kompensiert wird.

12. Signalempfänger umfassend einen Empfänger (400) und eine Filterschaltung gemäß eines der vorangehenden Ansprüche, wobei der Empfänger (400) eingerichtet ist, ein Signal (325a) über die Filterschaltung zu empfangen.

13. Signalanalysator (700) umfassend einen Signalempfänger gemäß Anspruch 12 und eine Analyseeinheit (600), wobei die Analyseeinheit (600) eingerichtet ist, das Signal (325a) zu analysieren.

14. Ein Verfahren zur Unterdrückung einer Signalverzerrung umfassend die Schritte:
- erzeugen eines Verzerrungsstroms zwischen einem Eingang eines Stromspannungswandlers (300) und einem zweiten Ausgang einer Frequenzweiche (200) durch einen ersten Signalstrom zwischen einem Eingang für eine Signalquelle (100) und einem erstem Ausgang der Frequenzweiche (200), wobei ein Eingang des Stromspannungswandlers (300) an den zweiten Ausgang der Frequenzweiche (200) angeschlossen ist,
- detektieren des ersten Signalstroms, wobei die Frequenzweiche (200) mindestens den Eingang, den ersten Ausgang und den zweiten Ausgang aufweist, wobei der Eingang in einem ersten Frequenzband eine erste Impedanz und in einem zweiten Frequenzband eine zweite Impedanz aufweist und das zweite Frequenzband höhere Frequenzen als das erste Frequenzband aufweist, wobei der erste Ausgang im ersten Frequenzband eine dritte Impedanz und im zweiten Frequenzband eine vierte Impedanz aufweist, und der Absolutbetrag der vierten Impedanz größer oder gleich ist als der Absolutbetrag der dritten Impedanz, wobei der zweite Ausgang im ersten Frequenzband eine fünfte Impedanz und im zweiten Frequenzband eine sechste Impedanz aufweist, und der Absolutbetrag der fünften Impedanz größer ist als der Absolutbetrag der sechsten Impedanz,
- kompensieren des Verzerrungsstroms durch Einkoppeln eines Kompensationsstroms innerhalb des Stromspannungswandlers (300), wobei der Kompensationsstrom dem Verzerrungsstrom entgegengesetzt und gleich groß ist.

## Claims

1. A filter circuit for suppressing a signal distortion, comprising a current-to-voltage converter (300), a frequency crossover (200) and a compensation circuit assembly (500), the frequency crossover (200) having at least one input for a signal source (100), a first output and a second output, the input of the frequency crossover (200) having a first impedance in a first frequency band and a second impedance in a second frequency band, and the second frequency band having a higher frequency than the first frequency band, the first output having a third impedance in the first frequency band and a fourth impedance in the second frequency band, and the absolute value of the fourth impedance being greater than or equal to the absolute value of the third impedance, the second output having a fifth impedance in the first frequency band and a sixth impedance in the second frequency band, and the absolute value of the fifth impedance being greater than the absolute value of the sixth impedance, an input of the current-to-voltage converter (300) being connected to the second output of the frequency crossover (200), the compensation circuit assembly (500) being configured to detect a first signal current between the input and the first output of the frequency crossover (200), the signal current creating a distortion current between the input of the current-to-voltage converter (300) and the second output of the frequency crossover (200), **characterized in that** the compensation circuit assembly (500) is configured to couple a compensation current within the current-to-voltage converter such that the compensation current is opposite and equal in magnitude to the distortion current, and to thus compensate the distortion current such that a distortion-free output signal is provided at the output of the current-to-voltage converter (300).

2. The filter circuit according to claim 1, wherein the compensation circuit assembly (500) is connected between the input of the frequency crossover (200) and the second output of the frequency crossover (200).

3. The filter circuit according to claim 1, wherein the compensation circuit assembly (500) is connected to the first output of the frequency crossover (200).

4. The filter circuit according to any one of the preceding claims, wherein the frequency crossover (200) has a first ohmic resistance (210) in the first output and a first capacitor (220) in the second output, wherein the first ohmic resistance (210) is greater than a line resistance in the input of the frequency crossover (200).

5. The filter circuit according to claim 1, 2 or 4, provided that claim 4 depends on claim 1 or 2, wherein the compensation circuit assembly (500) is configured to convert a signal voltage (205, 205a) at the input of the frequency crossover (200) into a compensation current (515), and the compensation current (515) is adapted to compensate the distortion current.

6. The filter circuit according to claim 5, wherein the compensation circuit assembly (500) has a second capacitor (520), the second capacitor (520) being connected to a high-impedance amplifier (530) in order to transfer the signal voltage (205, 205a) to the high-impedance amplifier (530), and the high-impedance amplifier (530) is configured to convert the signal voltage (205, 205a) into the compensation current (515).

7. The filter circuit according to claim 6, wherein the second capacitor (520) has the same capacity as the first capacitor (220).

8. The filter circuit according to claim 6 or 7, wherein the compensation current (515) is connected to the first capacitor (220) via a second ohmic resistance (510).

9. The filter circuit according to claim 8, wherein the second ohmic resistance (510) is equal in magnitude to the first ohmic resistance (210).

10. The filter circuit according to claim 3, wherein the compensation circuit assembly (500) has a current sensor, the current sensor being configured to detect a current via the first ohmic resistance (210), and the current sensor being further configured to control a controllable power source (550) such that a signal distorted by the distortion current is compensated at the output of the current-to-voltage converter (300).

11. The filter circuit according to claim 10, wherein the compensation circuit assembly (500) has a second ohmic resistance (510) between the output of the current-to-voltage converter and the controllable power source (550), and the distorted signal between the controllable power source (550) and the second ohmic resistance (510) is compensated.

12. A signal receiver comprising a receiver (400) and a filter circuit according to any one of the preceding claims, the receiver (400) being configured to receive a signal (325a) via the filter circuit.

13. A signal analyzer (700) comprising a signal receiver according to claim 12 and an analysis unit (600), the analysis unit (600) being configured to analyze the signal (325a).

14. A method for suppressing a signal distortion, comprising the following steps:
- creating a distortion current between an input of a current-to-voltage converter (300) and a second output of a frequency crossover (200) by a first signal current between an input for a signal source (100) and a first output of the frequency crossover (200), an input of the current-to-voltage converter (300) being connected to the second output of the frequency crossover (200),
- detecting the first signal current, the frequency crossover (200) comprising at least the input, the first output and the second output, the input having a first impedance in a first frequency band and a second impedance in a second frequency band, and the second frequency band having higher frequencies than the first frequency band, the first output having a third impedance in the first frequency band and a fourth impedance in the second frequency band, and the absolute value of the fourth impedance being greater than or equal to the absolute value of the third impedance, the second output having a fifth impedance in the first frequency band and a sixth impedance in the second frequency band, and the absolute value of the fifth impedance being greater than the absolute value of the sixth impedance,
- compensating the distortion current by coupling a compensation current within the current-to-voltage converter (300), the compensation current being opposite and equal in magnitude to the distortion current.

## Revendications

1. Circuit de filtrage pour réduire une distorsion de signal, comportant un convertisseur courant-tension (300), un diviseur de fréquences (200) et un arrangement de circuit de compensation (500), dans lequel le diviseur de fréquences (200) comporte au moins une entrée pour une source de signal (100), une première sortie et une deuxième sortie, dans lequel l'entrée du diviseur de fréquences (200) présente une première impédance dans une première bande de fréquences et une deuxième impédance dans une deuxième bande de fréquences et la deuxième bande de fréquences présente des fréquences plus élevées que la première bande de fréquences, dans lequel la première sortie présente une troisième impédance dans la première bande de fréquences et une quatrième impédance dans la deuxième bande de fréquences, et la valeur absolue de la quatrième impédance est supérieure ou égale à la valeur absolue de la troisième impédance, dans lequel la deuxième sortie présente une cinquième impédance dans la première bande de fréquences et une sixième impédance dans la deuxième bande de fréquences, et la valeur absolue de la cinquième impédance est supérieure à la valeur absolue de la sixième impédance, dans lequel une sortie du convertisseur courant-tension (300) est raccordée à la deuxième sortie du diviseur de fréquences (200), dans lequel l'arrangement de circuit de compensation (500) est configuré pour détecter un premier courant de signal entre l'entrée et la première sortie du diviseur de fréquences (200), dans lequel le courant de signal génère un courant de distorsion entre l'entrée du convertisseur courant-tension (300) et la deuxième sortie du diviseur de fréquences (200), **caractérisé en ce que** l'arrangement de circuit de compensation (500) est configuré pour injecter un courant de compensation dans le convertisseur courant-tension de telle sorte que le courant de compensation est opposé et de valeur égale au courant de distorsion et pour compenser ainsi le courant de distorsion de telle sorte qu'un signal de sortie sans distorsion est fourni à la sortie du convertisseur courant-tension (300).

2. Circuit de filtrage d'après la revendication 1, dans lequel l'arrangement de circuit de compensation (500) est raccordé entre l'entrée du diviseur de fréquences (200) et la deuxième sortie du diviseur de fréquences (200).

3. Circuit de filtrage d'après la revendication 1, dans lequel l'arrangement de circuit de compensation (500) est raccordé à la première sortie du diviseur de fréquences (200).

4. Circuit de filtrage d'après l'une des revendications précédentes, dans lequel le diviseur de fréquences (200) comporte une première résistance ohmique (210) dans la première sortie et un premier condensateur (220) dans la deuxième sortie, dans lequel la première résistance ohmique (210) est supérieure à une résistance de ligne dans l'entrée du diviseur de fréquences (200).

5. Circuit de filtrage d'après la revendication 1, 2 ou 4 si la revendication 4 dépend de la revendication 1 ou 2, dans lequel l'arrangement de circuit de compensation (500) est configuré pour convertir une tension de signal (205, 205a) à l'entrée du diviseur de fréquences (200) en un courant de compensation (515), et le courant de compensation (515) est adapté pour compenser le courant de distorsion.

6. Circuit de filtrage d'après la revendication 5, dans lequel l'arrangement de circuit de compensation (500) comporte un deuxième condensateur (520), le deuxième condensateur (520) est raccordé à un amplificateur de valeur ohmique élevée (530) afin de transmettre la tension de signal (205, 205a) à l'amplificateur de valeur ohmique élevée (530) et l'amplificateur de valeur ohmique élevée (530) est configuré pour convertir la tension de signal (205, 205a) en courant de compensation (515).

7. Circuit de filtrage d'après la revendication 6, dans lequel le deuxième condensateur (520) présente une capacité égale à celle du premier condensateur (220).

8. Circuit de filtrage d'après la revendication 6 ou 7, dans lequel le courant de compensation (515) est relié au premier condensateur (220) par une deuxième résistance ohmique (510).

9. Circuit de filtrage d'après la revendication 8, dans lequel la deuxième résistance ohmique (510) a exactement la même valeur que la première résistance ohmique (210).

10. Circuit de filtrage d'après la revendication 3, dans lequel l'arrangement de circuit de compensation (500) comporte un capteur de courant, dans lequel le capteur de courant est configuré pour détecter un courant à travers la première résistance ohmique (210) et le capteur de courant est configuré en outre pour piloter une source de courant réglable (550) de sorte qu'un signal distordu par un courant de distorsion est compensé à la sortie du convertisseur courant-tension (300).

11. Circuit de filtrage d'après la revendication 10, dans lequel l'arrangement de circuit de compensation (500) comporte une deuxième résistance ohmique (510) entre la sortie du convertisseur courant-tension et la source de courant pilotable (550) et le signal distordu est compensé entre la source de courant réglable (550) et la deuxième résistance ohmique (510).

12. Récepteur de signal comprenant un récepteur (400) et un circuit de filtrage d'après l'une des revendications précédentes, dans lequel le récepteur (400) est configuré pour recevoir un signal (325a) par le circuit de filtrage.

13. Analyseur de signal (700) comprenant un récepteur de signal d'après la revendication 12 et une unité d'analyse (600), dans lequel l'unité d'analyse (600) est configurée pour analyser le signal (325a).

14. Procédé de suppression d'une distorsion de signal comprenant les étapes :
- génération d'un courant de distorsion entre une entrée d'un convertisseur courant-tension (300) et une deuxième sortie d'un diviseur de fréquences (200) par un premier courant de signal entre une entrée pour une source de signal (100) et une première sortie du diviseur de fréquences (200), dans lequel une sortie du convertisseur courant-tension (300) est raccordée à la deuxième sortie du diviseur de fréquences (200),
- détection du premier courant de signal, dans lequel le diviseur de fréquences (200) comporte au moins l'entrée, la première sortie et la deuxième sortie, dans lequel l'entrée présente une première impédance dans une première bande de fréquences et une deuxième impédance dans une deuxième bande de fréquences et la deuxième bande de fréquences présente des fréquences plus élevées que la première bande de fréquences, dans lequel la première sortie présente une troisième impédance dans la première bande de fréquences et une quatrième impédance dans la deuxième bande de fréquences, et la valeur absolue de la quatrième impédance est supérieure ou égale à la valeur absolue de la troisième impédance, dans lequel la deuxième sortie présente une cinquième impédance dans la première bande de fréquences et une sixième impédance dans la deuxième bande de fréquences, et la valeur absolue de la cinquième impédance est supérieure à la valeur absolue de la sixième impédance,
- compensation du courant de distorsion par injection d'un courant de compensation dans le convertisseur courant-tension (300), dans lequel le courant de compensation est opposé et de valeur égale au courant de distorsion.
